# EUROPEAN PATENT SPECIFICATION

(11) **EP 0 816 177 B1**
(45) Date of publication and mention of the grant of the patent: **20.03.2002**
(21) Application number: 97304668.3
(22) Date of filing: 27.06.1997
(51) Int. Cl.: B60R 16/02

(54) **Electrical connection box for automotive vehicle**
Elektrischer Steckverbinder für ein Fahrzeug
Boîte de connexion électrique pour véhicule automobile

(30) Priority: 03.07.1996 JP 17351196
(43) Date of publication of application: 07.01.1998
(73) Proprietor: SUMITOMO WIRING SYSTEMS, LTD., Yokkaichi City Mie 510 (JP)
(72) Inventor: Sumida, Tetsuya, Yokkaichi-City, Mie, 510 (JP)
(74) Representative: Paget, Hugh Charles Edward

(56) References cited:
- DE-A- 2 823 666
- DE-A- 3 514 440
- DE-A- 4 313 462
- DE-C- 4 307 902

## Description

### BACKGROUND OF THE INVENTION

### 1. Field of the Invention

The present invention relates to an electrical connection box according the preamble of claim 1 and more particularly to an electrical connection box installed in the engine room of a car or other automotive vehicle. The box accommodates electrical devices. The invention also relates to an automotive vehicle, e.g. a car, having an engine room and an electrical connection box installed therein.

### 2. Description of Related Art

There have been proposed various kinds of electrical connection boxes accommodating various kinds of electrical devices such as a junction box, a relay box, a fusible link box, and an electronic control unit for use in a car. It is necessary to avoid or minimize the penetration of water into this kind of electrical connection box. In order to waterproof the electrical connection box, generally, a sealing packing is installed at the mating surfaces of the body and the cover of the electrical connection box, which is usually made of synthetic resin, to seal the box.

Because a relay accommodated inside a relay box and a fuse accommodated inside a fusible link box are heat releasing parts, heat released therefrom is retained in the sealed electrical connection box and thus the temperature therein rises. Further, when the electrical connection box is provided in the engine room, the temperature inside the box is raised by the heat of the engine.

Electronic control units are increasingly used in cars. An electronic control unit (ECU) is composed of an electronic circuit comprising heat-susceptible electronic components. Thus, with the increase in the environmental temperature of the ECU, the characteristics of the electronic circuit cannot be guaranteed, raising the possibility that the reliability of the ECU deteriorates. In order to improve the heat resistance of the electronic circuit, it is necessary to use expensive heat-resistant electronic parts, which increases the entire cost of parts of the car.

Thus, generally, an electrical connection box accommodating only the ECU is installed not in the engine room but in the interior (passenger space) of the car to reduce the environmental temperature of the ECU, but this increases the entire cost of the car and necessitates the formation of an additional space for accommodating the electrical connection box in the interior of the car.

When an ECU for use in an electronic fuel injection apparatus (EFI) of the engine is installed in the interior of the car, it is necessary to wire a wire harness for connecting the engine and the electronic control unit with each other from the inside of the engine room to the interior of the car. Therefore, it is necessary to use a long wire harness, which increases cost. In addition, it is necessary to form a wire harness insertion hole on a car body panel partitioning the engine room and the interior of the car, which increases the operation cost.

As one example of a prior art electrical connection box there is mentioned that shown in JP-U-3-57978 (Utility Model) in which fuses are mounted in apertures of a wall of a sealed housing component of the box. The wires projection away from this wall are covered by a cover which locks onto the housing component.

DE-A-4313462 describes an air-cooled compartment in the engine room of a motor vehicle according to the preamble of claim 1, containing temperature - sensitive devices such are a control apparatus and a battery. Passages for air flow are provided between the devices and between the devices and the compartment walls.

### SUMMARY OF THE INVENTION

The present invention aims to reduce or avoid the above-described problems. It is accordingly an object to provide an electrical connection box accommodating an electrical devices or parts susceptible to heat, while ensuring the good performance of the electrical devices or parts accommodated therein, and at the same time reducing cost and complication in manufacture of an automotive vehicle in which the electrical connection box is used.

According to this invention there is provided an electrical connection box, comprising a base and a peripheral wall upstanding from the base defining an exterior surface of the connection box and an interior space thereof. An interior wall upstanding from the base and located within the interior space sub-divides the interior space into a first accommodation portion and a second accommodation portion. The interior wall is located so that the first accommodation portion is, on at least two sides thereof, separated from the peripheral wall by an air gap. At least one electrical element susceptible to heat damage is located in the first accommodation portion, and at least one electrical element which in use releases heat is located in the second accommodation portion. The first accommodation portion is closed from the second accommodation portion so as to prevent passage of air from the second accommodation portion into the first accommodation portion.

By this arrangement, the electrical element susceptible to heat damage is well isolated from the heat from the heat-releasing element and exterior heating, e.g. by an engine of a car. A single box houses both elements.

Preferably the interior wall is located so that the first accommodation portion is separated on at least three sides thereof, more preferably four sides, from the peripheral wall by the air gap. Conveniently, the air gap is in communication with the second accommodation portion.

To provide a cooling effect, the electrical connection may have a cooling air inlet for admitting cooling air to the second accommodation portion and an air outlet from the second accommodation portion.

For water-tightness, the base may have an aperture through which wires pass into the first accommodation portion, a grommet sealing the aperture and a partitioning wall upstanding from the base in the first accommodation portion between the aperture and the electrical element located in the first accommodation portion.

Preferably the electrical connection box has a cover opposed to the base and means sealing the peripheral wall and the interior wall of the body to the cover.

Additional protection may be given by thermal insulation material mounted on at least one of (a) a face of the interior wall and (b) an interior face of the peripheral wall.

The invention further consists in the electrical connection box defined above installed in an automotive vehicle engine room.

The electrical element susceptible to heat damage installed in the first accommodation portion is for example a circuit comprising electronic components selected from the group comprising:
a control unit for an anti-lock braking system,
a control unit for a fuel injection system,
a control unit for a suspension control system, and
a control unit for an ignition control system.
The element which in use releases heat located in the second accommodation portion is for example selected from the group consisting of a relay, a fuse and a fusible link.

The invention further consists in an automotive vehicle having an engine room, an engine mounted in the engine room and, also mounted in the engine room, an electrical connection box of the invention as defined above.

For convenience and clarity, the electrical connection box is here described as having a base and upstanding walls, but it should be understood that in use the box may be installed in any appropriate orientation, e.g. with the base arranged vertically.

### BRIEF DESCRIPTION OF THE DRAWINGS

Fig. 1 is an exploded perspective view showing a first electrical connection box embodying the invention;
Fig. 2 is a sectional view on line A-A of Fig. 1;
Fig. 3 is a plan view showing the electrical connection box of Fig. 1, with the cover removed;
Fig. 4 is a diagrammatic illustration showing the electrical connection box of Fig. 1 installed in a car; and
Fig. 5 is plan view (with its cover removed) of a second electrical connection box embodying the present invention.

### DESCRIPTION OF THE PREFERRED EMBODIMENTS

Electrical connection-boxes according to the present invention and their installation will be described below with reference to drawings, by way of non-limitative example.

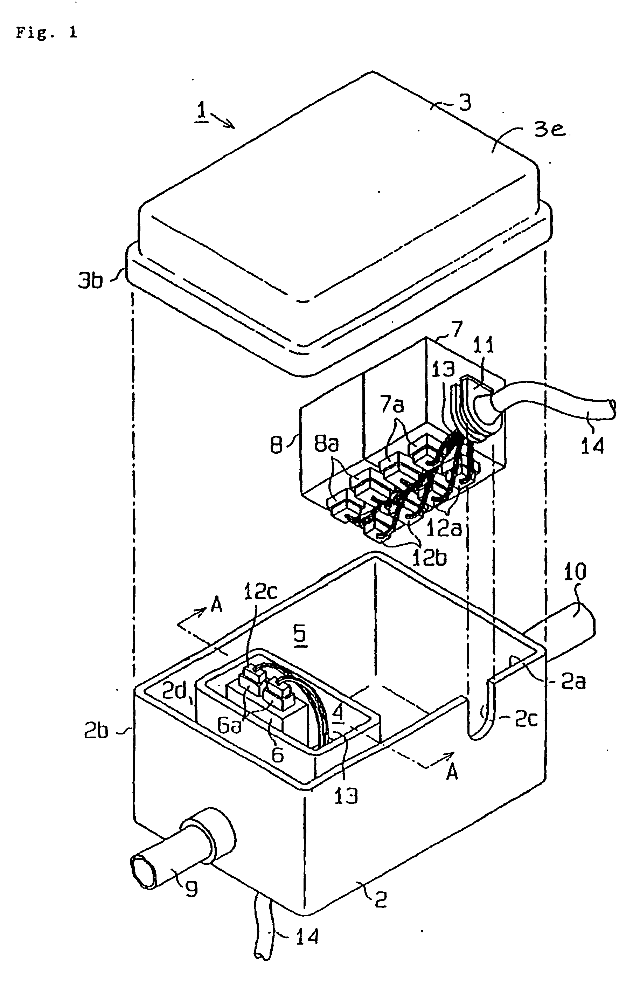

The electrical connection box 1 shown in Figs. 1 to 3 is for use in a car (automobile) and comprises a generally rectangular body 2 and a cover 3 closing the open upper end 2a of the body 2. The body 2 and the cover 3 are both formed of suitable synthetic resin.

The body 2 has a base 2e and an outer peripheral wall 2b standing up perpendicularly from the base 2e. The interior of the body 2 bounded by the peripheral wall 2b is partitioned into a generally rectangular first accommodation portion 4 surrounded by a partition wall 2d and a second accommodation portion 5 which in this embodiment entirely surrounds the first accommodation portion 4. That is to say, the body 2 has a double construction consisting of the first and second accommodation portions 4 and 5, with the first accommodation portion separated on all four sides from the peripheral wall 2b by an air gap. On three sides this air gap is narrow. By injection molding, the peripheral wall 2b, the partition wall 2d and the base 2e are formed integrally in one piece of suitable synthetic resin.

The first accommodation portion 4 accommodates an electronic control unit (ECU) 6 of an anti-lock braking control system (ABS) and an electronic fuel injection apparatus (EFI) of an engine. The second accommodation portion 5 accommodates a relay box 7 accommodating a relay of an electric circuit of a car and a fusible link box 8 accommodating a fuse of the electric circuit of the car. The electronic control unit 6, the relay box 7, and the fusible link box 8 are provided with connection portions 6a, 7a, and 8a, respectively. Connection portion 6a is directed toward the open upper end 2a of the body 2, whereas the connection portions 7a and 8a are directed toward the base of the body 2. In order to show the connection portions 7a and 8a clearly, they are shown viewed obliquely from below in Fig. 1.

A cooling air intake pipe 9 is installed on the peripheral wall 2b of the body 2 at the short side thereof close to the partition wall 2d, and an air exhaust pipe 10 is installed on the opposite short side of the peripheral wall 2b. The air inlet is thus positioned close to the first accommodation portion 4 and the exhaust pipe 10 is positioned close to the relay box 7 and fusible link box 8.

A U-shaped notch 2c is formed on the peripheral wall 2b of the body 2 close to the boxes 7,8. A waterproof grommet 11 made of rubber is installed in the notch 2c. A locking groove is formed on the periphery of the waterproof grommet 11. The locking groove engages the notch 2c, thus preventing water from penetrating into the second accommodation portion 5 from the gap between the waterproof grommet 11 and the notch 2c.

A wire harness 14 comprising bundled wires 13 having connectors 12a, 12b at the ends thereof is inserted through the waterproof grommet 11. The connectors 12a are connected with the connection portions 7a of the relay box 7, and the connectors 12b are connected with the connection portions 8a of the fusible link box 8.

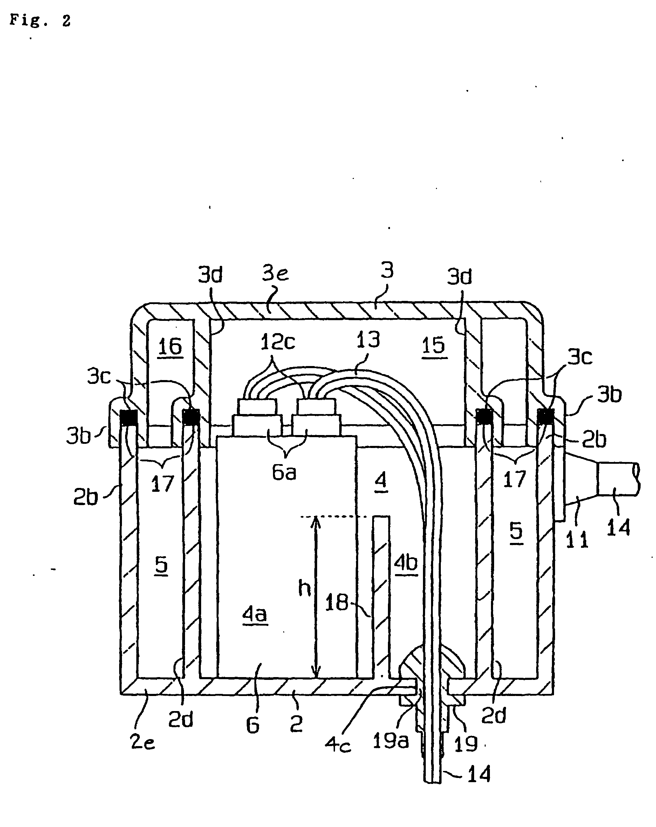

Fig. 2 shows a state in which the cover 3 is installed on the body 2. The interior of the cover 3 comprises a rectangular first accommodation portion 15 surrounded by a partition wall 3d and a second accommodation portion 16 surrounding the first accommodation portion 15 and bounded by a peripheral wall 36 which extends downwardly from the top wall 3e. The size and shape of the first and second accommodation portions 15 and 16 of the cover 3 correspond to those of the first and second accommodation portions 4, 5 of the body 2, respectively. That is to say, in correspondence to the interior of the body 2, the cover 3 has a double construction consisting of the first and second accommodation portions 15 and 16. By injection molding the top wall 3e the peripheral wall 3b and the partition wall 3d of the cover 3, and formed integrally in one piece of suitable synthetic resin.

Grooves 3c rectangular in section are formed at the lower end of the peripheral wall 3b and partition wall 3d of the cover 3, along the whole length of each wall. A waterproof sealing packing 17 made of an elastic material is located at the bottom of each groove 3c, so that when the cover 3 is installed on the body 2, the peripheral wall 2b of the body 2 engages the packing 17 in the groove 3c of the peripheral wall 3b of the cover 3, and the partition wall 2d of the body 2 engages the packing 17 in the groove 3c of the partition wall 3d of the cover 3, thus preventing water from penetrating into the first and second accommodation portions 4, 5 of the body 2 and into the first and second accommodation portions 15, 16 of the cover 3 through the gap between the body 2 and the cover 3. The first and second accommodation portions are fully sealed from each other.

The interior of the first accommodation portion 4 of the body 2 is partitioned by a partitioning wall 18 having a predetermined height (h) less than the height of the wall 2d, into a part 4a in which the electronic control unit 6 is accommodated and a part 4b at which a waterproof grommet 19 made of rubber is installed. A locking groove 19a is formed on the periphery of the waterproof grommet 19 and engages a through-hole 4c formed in the base wall 2e, thus preventing water from penetrating into the first accommodation portion 4 via the gap between the waterproof grommet 19 and the through-hole 4c. A wire harness 14 comprising bundled wires 13 each having a connector 12c at the end thereof is inserted through the waterproof grommet 19. The connectors 12c are connected with connection portions 6a of the electronic control unit 6.

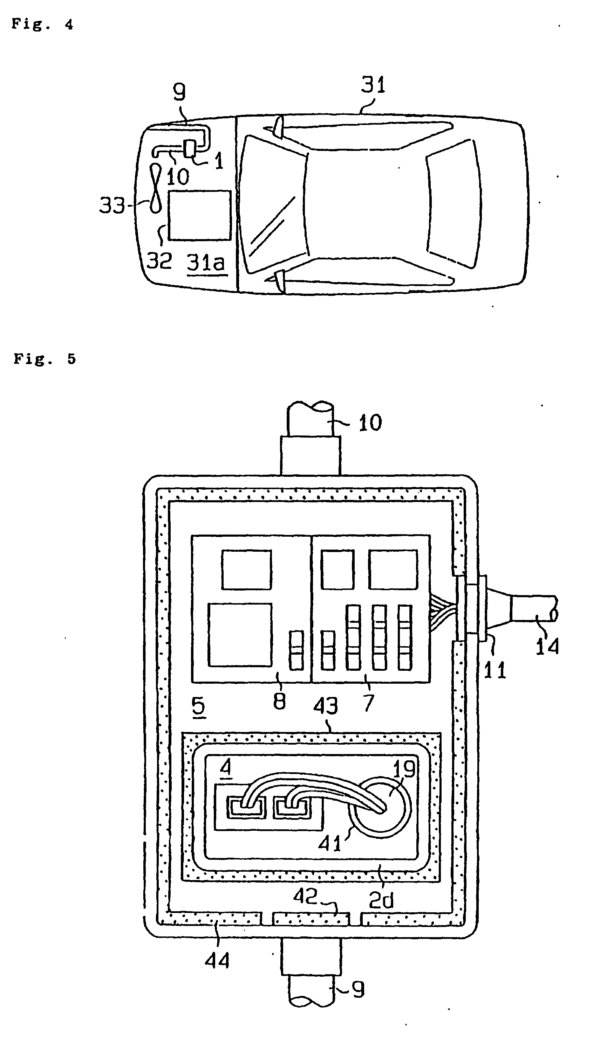

Fig. 4 shows the installation position of the electrical connection box 1 in a car 31. An engine 32 is installed in an engine room 31a of the car 31. The electrical connection box 1 is installed inside the engine room 31a, with the cover 3 positioned at the top and the base 2e of the body 2 at bottom. However, the box 1 may be installed with any orientation in the engine room. The end of the intake pipe 9 remote from the end thereof connected with the body 2 is open to the atmosphere at the outside of the car 31. The end of the exhaust pipe 10 remote from the end thereof connected with the body 2 is open in the vicinity of a radiator fan 33 of the engine.

The operation and effect of the electrical connection box of this embodiment are described below.

The relay accommodated in the relay box 7 and the fuse accommodated in the fusible link box 8 are heat-releasing devices. Because the electronic control unit 6 has an electronic circuit, there is a possibility that the characteristics of the electronic circuit cannot be ensured when the environmental temperature of the electronic control unit 6 rises and therefore that its reliability deteriorates. That is to say, the electronic control unit 6 is a device susceptible to heat.

Because the relay box 7 and the fusible link box 8 are accommodated in the portion 5, while the electronic control unit 6 is accommodated in the portion 4 which is separated by an air gap on all four sides from the peripheral wall 26, there is reduced possibility that the reliability of the electronic control unit 6 is deteriorated by the heat released from the relay box 7 and the fusible link box 8 and furthermore the heating effect of the car engine on the electronic control unit 6 is reduced. Accordingly, it is unnecessary to use heat resistant electronic parts to improve the heat-resistance of the electronic control unit 6. Hence, the entire cost of this part of the car can be reduced.

Further, in this embodiment, because the electronic control unit 6, the relay box 7, and the fusible link box 8 are accommodated in one electrical connection box 1, the cost can be less than that of separate electrical connection boxes dedicated to the electronic control unit and the heat-releasing elements separately, and space is saved. Because the electrical connection box 1 is positioned inside the engine room 31a, space in the interior (passenger room) of the car 31 is not used for it, and construction and assembly of the car are simplified.

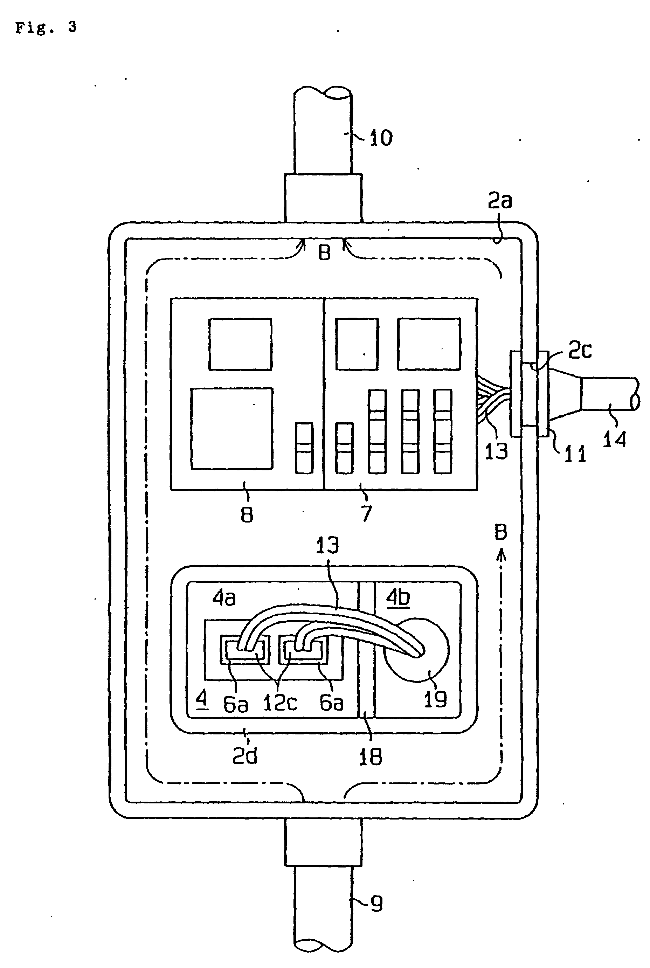

When the engine 32 of the car 31 starts and the radiator fan 33 rotates, a negative pressure is generated inside the engine room 31a, at least adjacent the end of the pipe 10. As a result, the air inside the box 1 is exhausted to the engine room 31a through the exhaust pipe 10. Consequently, cool air from outside the car 31 flows into the second accommodation portion 5 through the intake pipe 9. Accordingly, the air outside the car 31 is constantly introduced into the electrical connection box 1 through a path shown by the arrow B of Fig. 3.

Because the intake pipe 9 is positioned in the vicinity of the first accommodation portion 4, the electronic control unit 6 is cooled by the cool air which has been just introduced into box 1. Since the exhaust pipe 10 is positioned in the vicinity of the relay box 7 and the fusible link box 8, air which has cooled the relay box 7 and the fusible link box 8 and has thus been warmed does not flow backward toward the electronic control unit 6. Accordingly, the electronic control unit 6 which is susceptible to heat can be cooled efficiently.

When the cover 3 is installed on the body 2, the sealing packing 17 is sandwiched between the peripheral wall 2b of the body 2 and the groove 3c on the peripheral wall 3b of the cover 3. The wire harness 14 connected with the relay box 7 and the fusible link box 8 is inserted into the waterproof grommet 11 installed on the peripheral wall 2b of the body 2. Accordingly, the penetration of water from the outside, namely, the engine room 31a of the electrical connection box 1 into the box 1 can be securely prevented. Therefore, risk of loss of the reliability of the relay box 7 and the fusible link box 8 is low.

The sealing packing 17 is sandwiched between the partition wall 2d of the body 2 and the groove 3c formed on the partition wall 3d of the cover 3. Further, the wire harness 14 connected with the electronic control unit 6 is inserted into the waterproof grommet 19. Thus, the penetration of water into the first accommodation portion 4 can be prevented.

The first accommodation portion 4 has a higher degree of waterproofness than the second accommodation portion 5 owing to the sealing packings 17 provided between the peripheral walls 2b and 3b and between the partitioning walls 2d and 3d.

The partition wall 18 partitions the first accommodation portion 4 into two parts 4a, 4b. Thus, even when the degree of the waterproofness of the waterproof grommet 19 has decreased and water has penetrated into the part 4b via a gap between the waterproof grommet 19 and the through-hole 4c, the partition wall 18 reduces the risk of the water from reaching the electronic control unit 6. Further, because the waterproof grommet 19 is installed in the base 2e of the body 2, water which has penetrated into the part 4b can easily pass to the outside via the gap between the waterproof grommet 19 and the through-hole 4c.

Accordingly, even though water penetrates into the engine room 31a for example during high pressure cleaning of the car 31, the above-described construction prevents the penetration of water into the electronic control unit 6 reliably.

Because the electronic control unit 6 has an electronic circuit, its reliability may be deteriorated by exposure to water more quickly than that of the relay box 7 and fusible link box 8. In the embodiment, the electronic control unit 6 is very well protected from being exposed to water.

The embodiment of Figs. 1 to 3 may be modified as described below, while providing similar operation and effect.

The partition wall 18 shown in Fig. 3 may be replaced by a cylinder 41 surrounding the waterproof grommet 19, as shown in Fig. 5. In this case, the same operation and effect can be obtained by making the height of the cylinder 41 equal to the height (h) of the partition wall 18. The sectional configuration of the cylinder 41 may be as desired.

As shown in Fig. 5, a filter member 42 made of a porous material having air permeability and moisture-absorption property may be installed at the connection of the intake pipe 9 and the body 2 so that the filter member 42 removes water and dust from air which flows into the box 1 via the intake pipe 9. The filter member 42 keeps the inside of the box 1 clean, thus preventing the connection portions 6a, 7a, 8a from being exposed to dust which deteriorates the dielectric strength thereof when it becomes damp.

As shown in Fig. 5, a layer of heat-insulating material 43 may be bonded to the outer surface of the partition wall 2d of the body 2. The heat-insulating material 43 reduces heat transmission from inside the engine room 31a to the electronic control unit 6 through the partition wall 2d, thus enhancing the effect.

As also shown in Fig. 5, a layer of heat-insulating material 44 may be bonded to the inner surface of the peripheral wall 2b of the body 2. The heat-insulating material 44 likewise reduces heat transmission from inside the engine room 31a to the electronic control unit 6 through the peripheral wall 2b, thus enhancing the effect.

Not only the relay box 7 and the fusible link box 8, but other parts such as a junction box connected with electric wires which are branched from a wire harness and wired on a car body may be accommodated inside the second accommodation portion 4.

Not only the waterproof grommet 19, but also the waterproof grommet 11 may be installed in the base 2e of the body 2. In this construction, even though the waterproofness of the waterproof grommet 11 deteriorates and thus water penetrates into the box 1 via a gap between the waterproof grommet 11 and the body 2, water can easily discharge to the outside via this gap between the waterproof grommet 11 and the body 2.

In alternative embodiments, the partition wall 2d may join into the peripheral wall 2b, so that the first accommodation portion 4 is separated from the peripheral wall 2b by an air gap on only three sides or even only two sides. In these cases, the effect of the invention may be reduced, but may be sufficient, for example in the case of a car having an engine of lower power output which has lower heating effect in the engine room.

## Claims

1. An electrical connection box (1), comprising a base (2e), a peripheral wall (2b) upstanding from the base defining an exterior surface of said box and an interior space thereof, and at least one electrical element (7,8) which in use releases heat and at least one electrical element (6) susceptible to heat damage located in said interior space,
**characterised in that** an interior wall (2d) upstanding from the base and located within said interior space, sub-divides said interior space into a first accommodation portion (4) and a second accommodation portion (5), said interior wall being located so that said first accommodation portion (4) is, on at least two sides thereof, separated from said peripheral wall (2b) by an air gap, said electrical element (7,8) which in use releases heat being located in said second accommodation portion (5) and said electrical element (6) susceptible to heat damage being located in said first accommodation portion (4), and wherein said first accommodation portion (4) is closed from said second accommodation portion (5) so as to prevent passage of air from said second accommodation portion (5) into said first accommodation portion (4).

2. An electrical connection box according to claim 1 wherein said interior wall (2d) is located so that said first accommodation portion is separated on at least three sides thereof from said peripheral wall (2b) by said air gap.

3. An electrical connection box according to claim 1 wherein said interior wall (2d) is located so that said first accommodation portion (4) is separated on four sides thereof from said peripheral wall (2b) by said air gap.

4. An electrical connection box according to any one of claims 1 to 3 wherein said air gap is in communication with said second accommodation portion.

5. An electrical connection box according to any one of claims 1 to 4 having a cooling air inlet (9) for admitting cooling air to said second accommodation portion and an air outlet (10) from said second accommodation portion.

6. An electrical connection box according to any one of claims 1 to 5 having in said base (2e) an aperture (4c) through which wires pass into said first accommodation portion (4), a grommet (19) sealing said aperture (4c) and a partition wall (18) upstanding from said base in said first accommodation portion between said aperture (4c) and said electrical element (6) located in said first accommodation portion.

7. An electrical connection box according to any one of claims 1 to 6 wherein said base (2e), said peripheral wall (2b) and said interior wall (2d) are molded in one piece of resin material.

8. An electrical connection box according to any one of claims 1 to 7 having a cover (3) opposed to said base (2e) and means (17) sealing said peripheral wall (2b) and said interior wall (2d) to said cover.

9. An electrical connection box according to any one of claims 1 to 8 having thermal insulation material (43,44) mounted on at least one of (a) a face of said interior wall (2d) and (b) an interior face of said peripheral wall (2b).

10. An electrical connection box according to any one of claims 1 to 9 which is installed in an automotive vehicle engine room (31a).

11. An electrical connection box according to claim 10 wherein said electrical element (6) susceptible to heat damage installed in said first accommodation portion is a circuit comprising electronic components and comprising at least one of:
a control unit for an anti-lock braking system,
a control unit for a fuel injection system,
a control unit for a suspension control system, and
a control unit for an ignition control system.

12. An electrical connection box according to claim 11 wherein said element (7,8) which in use releases heat located in said second accommodation portion is selected from a relay, a fuse and a fusible link.

13. An automotive vehicle having an engine room, an engine mounted in said engine room and, also mounted in said engine room, an electrical connection box according to any one of claims 1 to 12.

## Patentansprüche

1. Elektrisches Verbindungs- bzw. Anschlußgehäuse bzw. -box (1), umfassend eine Basis (2e), eine Umfangswand (2b), welche von der Basis vorragt, welche eine äußere Fläche bzw. Oberfläche des Gehäuses und einen Innenraum derselben definiert, und wenigstens ein elektrisches Element (7, 8), welches bei einer Verwendung Wärme freisetzt, und wenigstens ein elektrisches Element (6), welches für eine Hitzebeschädigung anfällig ist, welches in dem Innenraum angeordnet ist,
**dadurch gekennzeichnet, daß** eine Innenwand (2d), welche von der Basis vorragt und in dem Innenraum angeordnet ist, den Innenraum in einen ersten Unterbringungs- bzw. Aufnahmeabschnitt- bzw. -bereich (4) und einen zweiten Aufnahmebereich (5) unterteilt, wobei die Innenwand so angeordnet ist, daß der erste Aufnahmebereich (4) an wenigstens zwei Seiten desselben von der Umfangswand (2b) durch einen Luftspalt getrennt ist, wobei das elektrische Element (7, 8), welches bei einer Verwendung Wärme freisetzt, in dem zweiten Aufnahmebereich (5) angeordnet ist, und das elektrische Element (6), welches für eine Hitzebeschädigung anfällig ist, in dem ersten Aufnahmebereich (4) angeordnet ist, und worin der erste Aufnahmebereich (4) von dem zweiten Aufnahmebereich (5) abgeschlossen ist, um einen Durchtritt von Luft von dem zweiten Aufnahmebereich (5) in den ersten Aufnahmebereich (4) zu verhindem.

2. Elektrisches Verbindungsgehäuse nach Anspruch 1, worin die Innenwand (2d) so angeordnet ist, daß der erste Aufnahmebereich an wenigstens drei Seiten desselben von der Umfangswand (2b) durch den Luftspalt getrennt ist.

3. Elektrisches Verbindungsgehäuse nach Anspruch 1, worin die Innenwand (2d) so angeordnet ist, daß der erste Aufnahmebereich (4) an vier Seiten desselben von der Umfangswand (2b) durch den Luftspalt getrennt ist.

4. Elektrisches Verbindungsgehäuse nach einem der Ansprüche 1 bis 3, worin der Luftspalt in Verbindung mit dem zweiten Aufnahmebereich steht.

5. Elektrisches Verbindungsgehäuse nach einem der Ansprüche 1 bis 4, welches einen Kühllufteinlaß (9) für ein Einlassen von Kühlluft zu dem zweiten Aufnahmebereich und einen Luftauslaß (10) aus dem zweiten Aufnahmebereich aufweist.

6. Elektrisches Verbindungsgehäuse nach einem der Ansprüche 1 bis 5, welches in der Basis (2e) eine Öffnung (4c) aufweist, durch welche Drähte in den ersten Aufnahmebereich (4) hindurchtreten, wobei eine Tülle bzw. Durchführungsdichtung (19) die Öffnung (4c) abdichtet und eine Trennwand (18) von der Basis in dem ersten Aufnahmebereich zwischen der Öffnung (4c) und dem elektrischen Element (6) aufragt, welches in dem ersten Aufnahmebereich angeordnet ist

7. Elektrisches Verbindungsgehäuse nach einem der Ansprüche 1 bis 6, worin die Basis (2e), die Umfangswand (2b) und die Innenwand (2d) aus einem Stück aus Harzmaterial geformt bzw. gegossen sind.

8. Elektrisches Verbindungsgehäuse nach einem der Ansprüche 1 bis 7, welches eine Abdeckung (3) gegenüberliegend der Basis (2e) und Mittel bzw. Einrichtungen (17) aufweist, welche die Umfangswand (2b) und die Innenwand (2d) zu der Abdeckung abdichten.

9. Elektrisches Verbindungsgehäuse nach einem der Ansprüche 1 bis 8, welches ein thermisches Isolationsmaterial (43, 44) an wenigstens einer von (a) einer Fläche bzw. Seite der Innenwand (2d) und (b) einer Innenseite bzw. -fläche der Umfangswand (2b) angeordnet aufweist.

10. Elektrisches Verbindungsgehäuse nach einem der Ansprüche 1 bis 9, welches in einem Kraftfahrzeug-Motorraum (31a) installiert ist.

11. Elektrisches Verbindungsgehäuse nach Anspruch 10, worin das elektrische Element (6), welches für eine Hitzebeschädigung anfällig ist, welches in dem ersten Aufnahmebereich installiert ist, ein Schaltkreis bzw. eine Schaltung ist, welche(r) elektronische Komponenten umfaßt und wenigstens eine umfaßt von:
einer Regel- bzw. Steuereinheit für ein Antiblockierbremssystem,
einer Regel- bzw. Steuereinheit für ein Kraftstoffeinspritzsystem,
eine Regel- bzw. Steuereinheit für ein Aufhängungsregel- bzw. -steuersystem, und
einer Regel- bzw. Steuereinheit für ein Zündregel- bzw. -steuersystem.

12. Elektrisches Verbindungsgehäuse nach Anspruch 11, worin das Element (7, 8), welches bei einer Verwendung Wärme freisetzt, welches in dem zweiten Aufnahmebereich angeordnet ist, aus einem Relais, einer Sicherung und einer Schmelzsicherung bzw. einem Schmelz- bzw. Sicherungsstreifen gewählt ist.

13. Kraftfahrzeug, welches einen Motorraum, einen in dem Motorraum angeordneten Motor und in dem Motorraum auch ein elektrisches Verbindungsgehäuse nach einem der Ansprüche 1 bis 12 montiert aufweist.

## Revendications

1. Boîte de connexion électrique (1), comprenant une base (2e), une paroi périphérique (2b) s'élevant à partir de la base et définissant une surface extérieure de la dite boîte et son espace intérieur, et au moins un élément électrique (7, 8) qui dégage de la chaleur en utilisation et au moins un élément électrique (6) sensible à une détérioration par la chaleur placés dans le dit espace intérieur,
**caractérisée en ce qu'**une paroi intérieure (2d) s'élevant à partir de la base et située dans le dit espace intérieur subdivise le dit espace intérieur en un premier logement (4) et un deuxième logement (5), la dite paroi intérieure étant placée de sorte que le dit premier logement (4) est séparé sur au moins deux de ses côtés de la dite paroi périphérique (2b) par un intervalle d'air, le dit élément électrique (7, 8) qui dégage de la chaleur en utilisation étant placé dans le dit deuxième logement (5) et le dit élément électrique (6) sensible à une détérioration par la chaleur étant placé dans le dit premier logement (4), et dans laquelle le dit premier logement (4) est isolé du dit deuxième logement (5) de façon à empêcher le passage d'air du dit deuxième logement (5) vers le dit premier logement (4).

2. Boîte de connexion électrique selon la revendication 1, dans laquelle la dite paroi intérieure (2d) est placée de sorte que le dit premier logement est séparé sur au moins trois de ses côtés de la dite paroi périphérique (2b) par le dit intervalle d'air.

3. Boîte de connexion électrique selon la revendication 1, dans laquelle la dite paroi intérieure (2d) est placée de sorte que le dit premier logement (4) est séparé sur quatre de ses côtés de la dite paroi périphérique (2b) par le dit intervalle d'air.

4. Boîte de connexion électrique selon une quelconque des revendications 1 à 3, dans laquelle le dit intervalle d'air est en communication avec le dit deuxième logement.

5. Boîte de connexion électrique selon une quelconque des revendications 1 à 4, ayant une entrée d'air de refroidissement (9) pour l'admission d'air de refroidissement vers le dit deuxième logement, et une sortie d'air (10) du dit deuxième logement.

6. Boîte de connexion électrique selon une quelconque des revendications 1 à 5, comportant, dans la dite base (2e), une ouverture (4c) à travers laquelle des câbles pénètrent dans le dit premier logement (4), un manchon de traversée (19) obturant de façon étanche la dite ouverture (4c) et une cloison (18) s'élevant à partir de la dite base dans le dit premier logement entre la dite ouverture (4c) et le dit élément électrique (6) placé dans le dit premier logement.

7. Boîte de connexion électrique selon une quelconque des revendications 1 à 6, dans laquelle la dite base (2e), la dite paroi périphérique (2b) et la dite paroi intérieure (2d) sont moulées en une seule pièce en résine.

8. Boîte de connexion électrique selon une quelconque des revendications 1 à 7, ayant un couvercle (3) opposé à la dite base (2e) et un moyen (17) de liaison étanche de la dite paroi périphérique (2b) et de la dite paroi intérieure (2d) au dit couvercle.

9. Boîte de connexion électrique selon une quelconque des revendications 1 à 8, comportant une matière d'isolation thermique (43, 44) montée sur au moins une face parmi (a) une face de la dite paroi intérieure (2d) et (b) une face intérieure de la dite paroi périphérique (2b).

10. Boîte de connexion électrique selon une quelconque des revendications 1 à 9, qui est installée dans un compartiment moteur (31a) d'un véhicule automobile.

11. Boîte de connexion électrique selon la revendication 10, dans laquelle le dit élément électrique (6) sensible à une détérioration par la chaleur, installé dans le dit premier logement, est un circuit comprenant des composants électroniques et comprenant au moins une unité parmi :
une unité de commande d'un système de freinage antiblocage,
une unité de commande d'un système d'injection de carburant,
une unité de commande d'un système de commande de suspension, et
une unité de commande d'un système de commande d'allumage.

12. Boîte de connexion électrique selon la revendication 11, dans laquelle le dit élément (7, 8) qui dégage de la chaleur en utilisation et est placé dans le dit deuxième logement est choisi parmi un relais, un fusible et une liaison fusible.

13. Véhicule automobile ayant un compartiment moteur, un moteur monté dans le dit compartiment moteur et, également montée dans le dit compartiment moteur, une boîte de connexion électrique selon une quelconque des revendications 1 à 12.
